# EUROPEAN PATENT SPECIFICATION

(11) **EP 0 293 828 B1**
(45) Date of publication and mention of the grant of the patent: **12.01.1994**
(21) Application number: 88108688.8
(22) Date of filing: 31.05.1988
(51) Int. Cl.: H03D 1/22

(54) **Circuit device for demodulating DSB modulated signals and method therefor**
Schaltungsanordnung zum Demodulieren DSB-modulierter Signale und Verfahren dafür
Circuit de démodulation de signaux modulés à bandes latérales doubles et son procédé

(30) Priority: 03.06.1987 JP 139237/87
(43) Date of publication of application: 07.12.1988
(73) Proprietor: SANYO ELECTRIC CO., LTD., Moriguchi-shi, Osaka (JP)
(72) Inventor: Ogawa, Ryuichi, Ohra-gun Gunma-ken (JP); Arai, Masashi, Ohra-gun Gunma-ken (JP)
(74) Representative: Glawe, Delfs, Moll & Partner

(56) References cited:
- EP-A- 0 256 287
- EP-A- 0 290 830
- EP-A- 0 291 826
- DE-A- 3 433 592
- DE-A- 3 733 096
- EBU REVIEW-TECHNICAL, no. 204, April 1984, pages 50-58, Brussel, BE; S.R. ELY et al.: "Design principles for VHF/FM radio receivers using the EBU radio-data system RDS"
- IEEE TRANSACTIONS ON CONSUMER ELECTRONICS, vol. CE-33, no. 3, August 1987, pages 383-393, IEEE, New York, US; R. OGAWA et al.: "Development of radio data system decoder IC's"
- PATENT ABSTRACTS OF JAPAN, vol. 12, no. 63 (E-585)[2910], 25th February 1988; & JP-A-62 206 929 (MITSUBISHI ELECTRIC CORP.) 11-09-1987

## Description

### BACKGROUND OF THE INVENTION

### Field of the Invention

The present invention relates generally to demodulators, and more particularly, to structure of demodulators for surely demodulating two DSB (double side-band) modulated signals having carriers orthogonal to each other and a demodulating method therefor.

### Description of the Prior Art

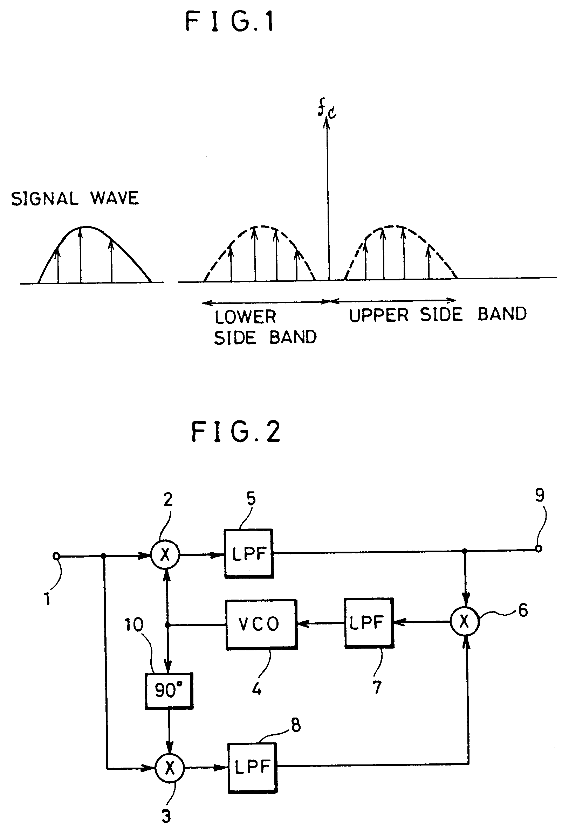

As one method for modulating signals to be transmitted, DSB modulation has been known. The DSB modulation is one of AM (amplitude modulation) in which the amplitude of a carrier is modulated with the amplitude of a signal wave. The frequency distribution of a modulated wave in the DSB modulation is as shown in Fig. 1. More specifically, there exist an upper side band and a lower side band symmetric with respect to a carrier frequency fc. The upper side band and the lower side band include the same information. The width of each frequency range thereof is the same as that of the signal wave. The phase differences between the side bands and the carrier are ϑ and -ϑ, respectively.

As one circuit for demodulating particularly a carrier suppressed DSB modulated signal, of the above described DSB modulated signals, a Costas loop as shown in Fig. 2 has been known. The Costas loop is described in, for example, Journal "EBU Review Technical", No. 204, April 1984, p. 53 and DE-A-34 33 592.

The Costas loop is one of synchronous detection structure. The Costas loop regenerates a carrier from a DSB modulated signal as received, to perform DSB demodulation using the regenerated carrier. More specifically, the Costas loop multiplies a quadrature synchronous (referred to as QS hereinafter) detected signal by an in-phase synchronous (referred to as IPS hereinafter) detected signal, to use a signal obtained by the multiplication as a control voltage of a PLL (phase locked loop). Consequently, even if the phase of the carrier is inverted at a zero cross point of an envelope of the DSB modulated signal, the carrier frequency can be detected, so that DSB demodulation can be performed.

Referring to Fig. 2, the Costas loop comprises an IPS detection output path, a QS detection output path and a carrier regeneration circuitry.

The IPS detection output path comprises a multiplier 2 for multiplying a DSB modulation signal from an input terminal 1 by a signal from a VCO (Voltage Controlled Oscillator) 4, and a low pass filter (LPF) 5 for passing a predetermined low frequency component of a signal from the multiplier 2. The low pass filter 5 passes a frequency component corresponding to a frequency range of a DSB signal, of the signals from the multiplier 2.

The QS detection output path comprises a phase shifter 10 for shifting the phase of a signal from the VCO 4 by 90°, multiplier 3 for multiplying a signal from the phase shifter 10 by the DSB modulated signal from the input terminal 1, and a low pass filter 8 for passing a predetermined low frequency component of an output of the multiplier 3. Functions of the multiplier 3 and the low pass filter 8 are the same as those of the multiplier 2 and the low pass filter 5, respectively.

The carrier regeneration circuitry comprises a multiplier 6 for multiplying a signal from the low pass filter 5 by a signal from the low pass filter 8, a low pass filter 7 for passing a predetermined low frequency component of an output of the multiplier 6, and the VCO 4 responsive to a signal voltage from the low pass filter 7 for changing a signal frequency as generated. A free running frequency of the VCO 4 is set to a carrier frequency of the DSB modulated signal or the vicinity thereof.

As described in the foregoing, in the Costas loop, the product of modulated signal components orthogonal to each other is obtained. The obtained product is used as a VCO control signal. The operation will be described. It is assumed that a loop comprising the VCO 4, the multiplier 3, the low pass filter 8, the multiplier 6, and the low pass filter 7 forms a PLL loop in response to a polarity of the output signals from the multipliers 2 and 3 and the polarity of the output signal from the VCO 4. The PLL generally locks to an input signal in a quadrature phase relation. Thus, if the loop on the lower side in Fig. 2 forms the PLL loop, the signal from the phase shifter 10 and an input carrier from the input terminal 1 have the same frequency and a phase difference of 90°. Thus, a regenerated carrier (non-modulated carrier) having the same frequency and the same phases as those of the input carrier is outputted from the VCO 4. Thus, if the multiplier 2 multiplies an input DSB modulated signal by the regenerated carrier and the low pass filter 5 eliminates an unnecessary high frequency component, an AM (amplitude modulation) detection output, i.e., a DSB demodulated signal is supplied to an output terminal 9.

On the other hand, leakage of a quadrature signal caused by the phase shift is outputted through the multiplier 3 and the low pass filter 8. Thus, the multiplier 6 multiplies demodulated DSB signals from the low pass filters 5 and 8, and the low pass filter 7 eliminates a high frequency component, then a signal voltage corresponding to the phase error between the input carrier and the regenerated carrier is obtained. The VCO 4 controls the frequency thereof, by receiving signal voltage from the low pass filter 7 as a control voltage so as to make the phase error be zero, developing a regenerated carrier locked to the input carrier.

Then, it is assumed that the envelop of the input DSB modulated signal reaches the zero cross point and the phase of the input carrier is inverted. If the loop on the lower side in Fig. 2 has formed the PLL loop before that point, the quadrature phase relation between the input carrier and the output of the phase shifter 10 is maintained. Thus, a regenerated carrier is outputted from the VCO 4, which phase is continuous with the phase of the regenerated carrier which has been being outputted. Consequently, a DSB demodulated signal for an inverted polarity signal is obtained from the low pass filter 5. On the other hand, the multiplier 6 multiplies the output signals from the low pass filters 5 and 8. Thus, even if the phase of the input carrier is inverted, a phase error voltage which is not affected by the phase inversion is applied to the VCO 4 through the low pass filter 7. As a result, the regenerated carrier locked to the input carrier (exactly, having a phase difference of 180°) is always obtained from the VCO 4, so that DSB demodulation can be correctly performed.

As other circuits for demodulating a DSB modulated signal, a remodulation compare circuit, a reverse modulation circuit, a delay detection circuit and the like have been known in the art.

Meanwhile, a broadcasting system has been proposed in which digital data such as channel selection is multiplexed on an FM (frequency modulated) radio signal, to be transmitted. This broadcasting system is referred to as RDS (radio data system), the specification thereof being prepared by EBU (European Broadcasting Union). In this RDS, data such as a broadcasting program, time and channel selection are coded, and then a carrier having a frequency of 57 KHz is DSB-modulated by a coded signal. The DSB modulated signal is superimposed on the FM radio signal, to be transmitted.

On the other hand, a system has been also proposed in which a carrier having a frequency of 57 KHz is amplitude-modulated by a signal indicating traffic information, and the amplitude-modulated (AM) signal is superimposed on an FM radio signal, to be transmitted. This system is referred to as an ARI (autofahrer rundfunk information) system. Information in both the systems is transmitted employing carriers having the same frequency (57 KHz). Thus, the phases of the carriers thereof are set to be in a quadrature relation so that the information can be identified.

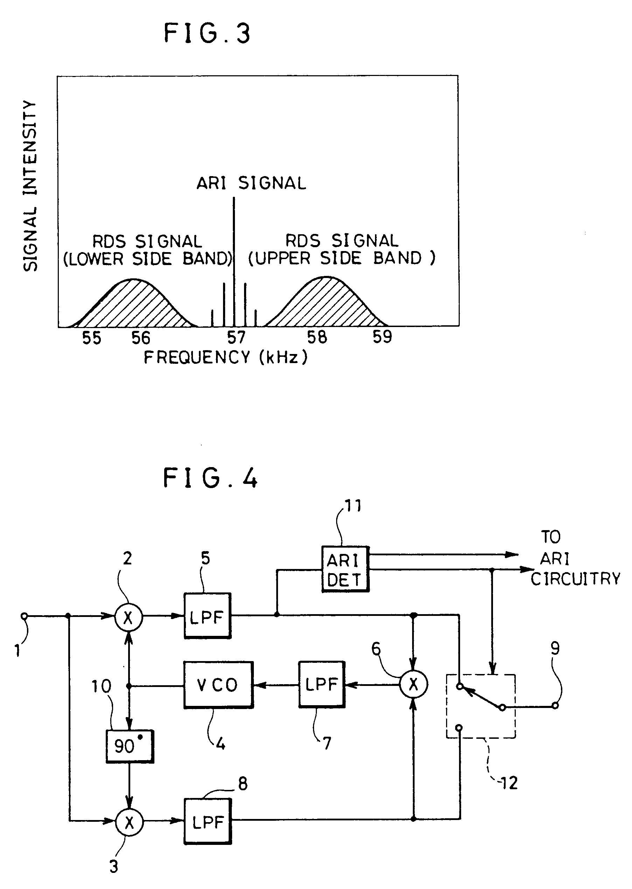

Fig. 3 shows frequency spectrums of an RDS signal and an ARI signal. As shown in Fig. 3, the RDS signal has an upper side band and a lower side band which are distributed at a lower level in the vicinity of the carrier of 57 KHz. The carrier of the RDS signal is suppressed. Similarly, the ARI signal has an upper side band and a lower side band with the carrier of 57 KHz being a center frequency. The carrier of the ARI signal is not suppressed. The signal level of the ARI signal is higher, by approximately 10 dB, than that of the RDS signal. In other words, the amplitude of the ARI signal is about three times that of the RDS signal.

If the Costas loop circuit shown in Fig. 2 is employed, the above described RDS signal can be demodulated. However, there is a case where the RDS signal and the ARI signal may be simultaneously transmitted. In this case, the above described Costas loop circuit can not supply the RDS demodulated signal to the output terminal 9. As described above, the RDS signal is a carrier suppressed DSB modulated signal, and the signal level thereof is less than that of the ARI signal. Thus, when the RDS signal and the ARI signal are simultaneously applied to the input terminal 1, the VCO 4 is controlled by the carrier of the ARI signal which is more dominant than the RDS signal, so that the RDS signal is synchronously detected by the multiplier 3. More specifically, when the output of the VCO 4 is controlled by the carrier of the ARI signal, the output of the VCO 4 becomes a signal synchronized in phase with the carrier of the ARI signal. Thus, the demodulated ARI signal is always obtained from the low pass filter 5. On the other hand, the phases of the modulated RDS signal and the modulated ARI signal are in a quadrature relation, so that the demodulated RDS signal is outputted from the multiplier 3. Thus, the demodulated RDS signal is not applied to the output terminal 9.

As described in the foregoing, the carriers of the modulated RDS signal and the modulated ARI signal are orthogonal to each other in the phase, and the carrier of the modulated RDS signal is suppressed while the carrier of the modulated ARI signal is not suppressed. Thus, if the RDS signal and the ARI signal are simultaneously received, the above described phenomenon always occurs.

### SUMMARY OF THE INVENTION

An object of the present invention is to provide a demodulator which can DSB-demodulate any one of two AM signals having carriers with phases in a quadrature relation and the same frequency even if these AM signals are simultaneously applied, and to provide a demodulating method therefor.

Another object of the present invention is to provide a demodulator which can surely DSB-demodulate a carrier suppressed AM signal even if a carrier suppressed AM signal and a carrier non-suppressed AM signal in a quadrature relation to each other are simultaneously applied, and a demodulating method therefor.

Still another object of the present invention is to provide a demodulator which provides compatibility for an RDS signal and an ARI signal, and a demodulating method therefor.

The demodulator according to the present invention comprises a first detecting circuitry for performing IPS (in-phase synchronous) detection of an input AM signal, second detecting circuitry for performing QS (quadrature synchronous) detection of the input AM signal, a detector for determining whether or not a demodulated component of a first AM signal is included in an output of the first detecting circuitry, and a selector responsive to an output of the detector for selectively passing any one of an IPS detected output and a QS detected output.

If the input AM signal is a signal obtained by quadrature modulation of the carrier suppressed AM signal and the carrier non-suppressed AM signal, the detector determines whether or not there exists a demodulated component of the carrier non-suppressed AM signal in a received signal. The selector is responsive to a presence detecting signal from the detector for selecting the QS detected output to output the same.

The demodulating method according to the present invention comprises the steps of performing IPS detection of the input AM signal, performing QS detection of the input AM signal, determining whether or not a demodulated component of a predetermined AM signal is included in the IPS detected output, and selectively passing either the IPS detected output or the QS detected output in response to the result of the determination in the determining step.

By the above described structure, if there is a difference in intensity between the quadrature AM signal components, the dominant signal component is detected to control the selector in response to the result of this detection, so that a DSB demodulated signal of the less-dominant signal component is surely obtained.

Furthermore, in the case in which the signals are independently and separately applied, if a dominant signal (for example, the ARI signal) does not exist, the selector selects a less-dominant signal (for example, the RDS signal) of the IPS detected output to output the same.

Additionally, processing of the dominant signal component can be performed by the output of the detector because the detector detects the dominant signal.

Thus, there is provided a demodulator which provides compatibility for the dominant signal, i.e., the carrier non-suppressed AM signal and the less-dominant signal, i.e., the carrier suppressed AM signal.

These objects and other objects, features, aspects and advantages of the present invention will become more apparent from the following detailed description of the present invention when taken in conjunction with the accompanying drawings.

### BRIEF DESCRIPTION OF THE DRAWINGS

Fig.1 is a diagram showing a frequency spectrum of a DSB modulated signal;
Fig. 2 is a diagram showing a Costas loop circuit which is one of conventional DSB demodulating circuitry;
Fig. 3 is a diagram showing frequency spectrums of a modulated ARI signal and a modulated RDS signal;
Fig. 4 is a diagram showing structure of DSB demodulating circuitry according to an embodiment of the present invention, showing structure in which the present invention is applied to a Costas loop circuit;
Fig. 5 is a diagram showing structure of DSB demodulating circuitry according to another embodiment of the present invention, showing structure in which the present invention is applied to a redmodulation compare circuit;
Fig. 6 is a diagram showing structure of DSB demodulating circuitry according to still another embodiment of the present invention, showing structure in which the present invention is applied to another remodulation compare circuit; and
Fig. 7 is a diagram showing structure of DSB demodulating circuitry according to a further embodiment of the present invention, showing structure in which the present invention is applied to a reverse modulation circuit.

### DESCRIPTION OF THE PREFERRED EMBODIMENTS

Fig. 4 is a diagram showing structure of demodulating circuitry according to an embodiment of the present invention, showing structure in which the present invention is applied to the Costas loop circuit in Fig. 2. In Fig. 4, portions corresponding to the components shown in Fig. 2 have the same reference numerals.

Referring to Fig. 4, in addition to the structure shown in Fig. 2, there are provided an ARI detector 11 for determining whether or not demodulated ARI signal is included in an output of a low pass filter 5, and a selector 12 responsive to an output of the ARI detector 11 for selectively passing one of the outputs of low pass filters 5 and 8.

The ARI detector 11 comprises, for example, a low pass filter and a level detector, although the configuration thereof is not explicitly shown in the figure. A modulated RDS signal is a carrier suppressed AM signal. An RDS signal demodulated by a multiplier 2 and the low pass filter 5 includes only AC component and does not include DC component. An ARI signal includes a traffic information broadcasting station identifying signal SK (sender kennung), a traffic information region identifying signal BK (bereichs kennung) and an identifying signal DK (durchsage kennung) indicating that the traffic information is on broadcasting. The ARI signal is obtained by amplitude modulation of a carrier having a frequency of 57 KHz with a BK signal and a DK signal each having a low frequency. The ARI signal demodulated by the multiplier 2 and the low pass filter 5 includes DC component. Thus, the time constant of a low pass filter included in the ARI detector 11 is set to be sufficiently larger than those of the low pass filters 5 and 8, to almost eliminate AC component. Consequently, DC component of the demodulated ARI signal is obtained. If the DC level detected by the level detector is compared with a predetermined value, it can be determined whether or not the ARI signal is demodulated. A detection signal from the ARI detector 11 is also applied to a circuitry for processing the ARI signal, for example, a DK signal identifying circuit, to be used as a control signal of the ARI signal processing circuitry and a signal for detecting the DK signal and the BK signal. The selector 12 applies the output of the low pass filter 8 to an output terminal 9 (in the state contrary to that shown in Fig. 4) when the ARI detector 11 detects the ARI signal while otherwise applying the output of the low pass filter 5 to the output terminal 9. The operation will be described.

Description is now made on the case in which only the RDS signal is applied to an input terminal 1. In this case, a loop on the lower side in Fig. 4 forms a PLL loop, to lock to the carrier of the modulated RDS signal. Since the PLL loop includes a phase shifter 10 for shifting an output of a VCO 4 by 90° in the phase, a regenerated carrier synchronized in phase with the carrier of the modulated RDS signal is outputted from the VCO 4. Thus, if the multiplier 2 multiplies the modulated RDS signal by the regenerated carrier and the low pass filter 5 performs filter processing of the result of the multiplication, it follows that IPS detection and demodulation of the modulated RDS signal are performed, so that a demodulated RDS signal is obtained. Since the demodulated RDS signal includes only AC component, the ARI detector 11 for detecting the DC level of the received signal generates a signal indicating that only a signal including no DC component, i.e., the RDS signal is being received. The selector 12 is responsive to an output of the ARI detector 11 for applying the output of the low pass filter 5 to the output terminal 9. Consequently, the demodulated RDS signal is obtained at the output terminal 9. Thus, if only the RDS signal is being received, the same structure as that of the Costas loop circuit shown in Fig. 2 is provided, so that a DSB demodulated RDS signal is obtained at the output terminal 9.

Description is now made on an operation to occur when the ARI signal and the RDS signal are simultaneously applied to the input terminal 1. In this case, the PLL loop formed by the loop on the lower side in Fig. 2 locks to an ARI signal having a dominant carrier. Thus, a regenerated carrier synchronized in phase with the carrier of the ARI signal is outputted from the VCO 4. As a result, the ARI signal as synchronously detected is outputted from the multiplier 2 and the low pass filter 5. A regenerated carrier synchronized in a quadrature relation with the carrier of the ARI signal and synchronized in phase with the carrier of the RDS signal is outputted from the phase shifter 10. Thus, an output obtained by quadrature detection of the ARI signal and synchronous detection of the RDS signal is obtained from the multiplier 3. Consequently, the demodulated RDS signal is outputted from the multiplier 3 and the low pass filter 8. The ARI detector 11 receives the ARI signal as detected and demodulated, to apply to the selector 12 a signal indicating that the ARI signal is being received. The selector 12 responsively applies the output of the low pass filter 8 to the output terminal 9. Thus, even if the ARI signal and the RDS signal are simultaneously received, the demodulated RDS signal can be surely applied to the output terminal 9. The ARI signal as detected and demodulated is applied to a circuit for detecting the BK signal and the DK signal or the like, through the ARI detector 11. Consequently, an ARI signal processing operation is performed therein. The ARI signal is an identifying signal. Actual traffic information is broadcasted in an ordinary FM broadcasting program.

As DSB demodulating circuitry, a remodulation compare circuit, a reverse modulation circuit, a square loop, a delay detection circuit and the like have been also known.

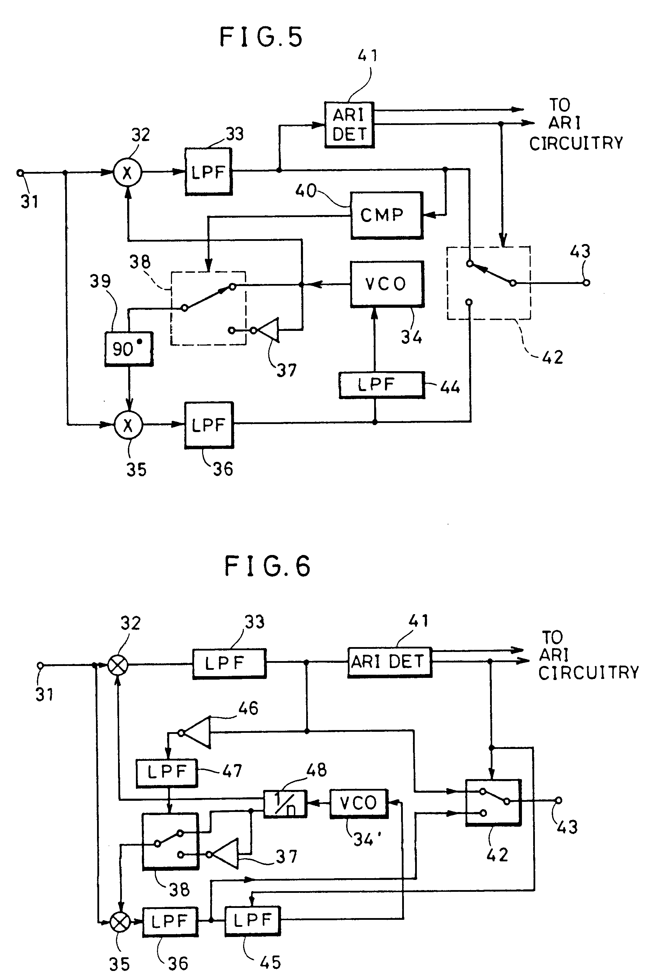

Fig. 5 is a diagram showing structure in which the present invention is applied to the remodulation compare circuit. Referring to Fig. 5, the remodulation compare circuit comprises a first synchronous detection path and a second synchronous detection path.

The first synchronous detection path comprises a multiplier 32 for multiplying a signal applied through an input terminal 31 by an output of a VCO 34, and a low pass filter 33 for passing only a predetermined low frequency component of an output of the multiplier 32.

The second synchronous detection path comprises an inverter 37 for inverting and amplifying the output of the VCO 34 to output the same, a selector 38 responsive to an output of a comparator 40 for outputting either the output of the VCO 34 or an output of the inverter 37, thereby to modulate the output of the VCO 34 with the output of the comparator 40, a phase shifter 39 for shifting an output of the selector 38 by 90° in the phase, a multiplier 35 for multiplying an output of the phase shifter 39 by the input signal from the input terminal 31, and a low pass filters 36 and 44 for passing a predetermined low frequency component of an output of the multiplier 35 to apply a control voltage to the VCO 34. The comparator 40 compares an output of the low pass filter 33 with a predetermined reference level and detects a zero cross point of an envelope of the output of the low pass filter 33, i.e., a demodulated DSB signal, to switch the output of the selector 38 in response to the output of the low pass filter 33. More specifically, in the DSB modulated signal, every time the envelop reaches the zero cross point, the phase of the carrier is inverted. Thus, every time the output of the low pass filter 33 crosses a reference level of the comparator 40 (or depending on whether the output of the low pass filter 33 is "0" or "1"), the phase of the output of the VCO 34 is inverted. Consequently, a regenerated carrier can be obtained, whose phase is continuous with the phase of the carrier of the input DSB modulated signal, so that the RDS signal can be demodulated.

In order to provide compatibility with the ARI signal, there are provided an ARI detector 41 for determining whether or not the output of the low pass filter 33 includes a demodulated ARI signal, and a selector 42 responsive to an output of the ARI detector 41 for selectively passing one of the outputs of the low pass filters 33 and 36. An output of the selector 42 is applied to an output terminal 43.

The ARI detector 41 has the same structure as that of the ARI detector 11 shown in Fig. 4. The selector 42 selects the output of the low pass filter 36 when the output of the ARI detector 41 indicates the presence of the ARI signal while otherwise selecting the output of the low pass filter 33. The operation will be briefly described.

Description is now made on the case in which only the modulated RDS signal is applied. It is assumed that a regenerated carrier locked to the input carrier is generated from the VCO 34 by the PLL loop in the state shown in Fig. 5. A regenerated carrier synchronized in phase with the input carrier is outputted from the VCO 34. On the other hand, a regenerated carrier synchronized in a quadrature phase relation with the input carrier is outputted from the 90° phase shifter 39. Thus, a signal obtained by IPS detection of the modulated RDS signal is obtained from the multiplier 32. The obtained signal is passed through the low pass filter 33 so that a demodulated RDS signal is obtained. Since the ARI signal is not included in the output from the low pass filter 33, the ARI detector 41 controls the selector 42, to apply the output of the low pass filter 33 to the output terminal 43.

On the other hand, the multiplier 35 performs QS detection of the modulated RDS signal, to apply the same to low pass filters 36 and 44. A voltage indicating the phase error between the input carrier and the regenerated carrier from the phase shifter 39 is outputted from the low pass filters 36 and 44. The phase error voltage is used as a control voltage of the VCO 34.

It is assumed that the envelope of the modulated RDS signal reaches the zero cross point so that the phase of the input carrier is inverted. On this occasion, the polarity of the output of the low pass filter 33 is changed. The change of the polarity is detected by the comparator 40. The comparator 40 switches an input of the selector 38 in response to the change of the polarity (or the zero cross point), to apply the output of the inverter 37 to the phase shifter 39. Thus, a regenerated carrier in phase with the input carrier is always applied to the phase shifter 39.

The multiplier 35 performs QS detection of the modulated RDS signal, to apply the QS detected signal to the low pass filters 36 and 44. Consequently, a signal voltage proportional to the phase difference between the input carrier from the input terminal 31 and the regenerated carrier from the phase shifter 39 is applied to the VCO 34 as a frequency control voltage through the low pass filters 36 and 44.

On the other hand, a regenerated carrier having a phase in a relation of inversion to the phase of the input carrier (a 180° phase difference) is outputted from the VCO 34. Thus, IPS detection (or synchronous detection in 180° out of phase) considering the polarity is performed by the multiplier 32, so that the DSB demodulated signal is obtained from the low pass filter 33.

If the modulated ARI signal and the modulated RDS signal are simultaneously applied, the PLL locks to the dominant modulated ARI signal having a carrier. Thus, the multiplier 32 performs IPS detection of the modulated ARI signal, to apply the same to the low pass filter 33. The demodulated ARI signal is obtained from the low pass filter 33. The ARI detector 41 applies the demodulated ARI signal to ARI signal processing circuitry, as well as detects the presence of the demodulated ARI signal to apply the detection signal to the selector 42. The selector 42 responsively applies the output of the low pass filter 36 to the output terminal 43.

Since the carriers of the modulated ARI signal and the modulated RDS signal are orthogonal to each other, the multiplier 35 performs IPS detection of the modulated RDS signal as well as QS detection of the modulated ARI signal. The QS detected output is used as a control voltage of the VCO 34 through the low pass filters 36. The IPS detected output becomes a demodulated RDS signal through the low pass filters 36 and 44, to be applied to the output terminal 43 through the selector 42. Consequently, the modulated ARI signal and the modulated RDS signal are surely DSB-demodulated, and the demodulated RDS signal is always outputted from the output terminal 43.

Fig. 6 is a diagram showing another structure in which the present invention is applied to the remodulation compare circuit. Portions corresponding to those in the structure shown in Fig. 5 have the same reference numerals.

Referring to Fig. 6, in order to form a control signal of a selector 38, there are provided an inverter 46 for inverting and amplifying an output of a low pass filter 33, and a low pass filter 47 for passing a predetermined low frequency component of an output of the inverter 46. The structure consisting of the inverter 46 and the low pass filter 47 corresponds to the comparator 40 shown in Fig. 5, which detects a zero cross point of an envelop of an input modulated DSB signal, i.e., a demodulated DSB signal.

In order to develop regenerated carriers orthogonal to each other, there is provided a frequency divider 48 for frequency-dividing an output of a VCO 34' in a predetermined ratio and deriving two signals having a phase difference of 90°, to apply one of the two signals to a multiplier 32 while applying the other thereof to the selector 38. A signal applied from the frequency divider 48 to the multiplier 32 is a regenerated carrier synchronized in phase with an input carrier while a signal applied to the selector 38 is a regenerated carrier synchronized in a quadrature relation with the input carrier.

In order to switch a loop filter constant of a PLL circuit, there are provided a low pass filter 36 receiving an output of a multiplier 35, and a low pass filter 45 receiving an output of the low pass filter 36 to apply a low frequency component to the VCO 34'. The output of the low pass filter 36 is also applied to a selector 42. The low pass filter 45 is activated in response to an ARI detection signal from an ARI detector 41, to perform a filtering operation. Otherwise, the low pass filter 45 passes the output of the low pass filter 36 without further additional filtering. The low pass filter 45 is provided for the following reason.

The multiplier 35 performs quadrature detection of a modulated ARI signal as well as synchronous detection of a modulated RDS signal on an input signal including an ARI signal and an RDS signal. The output of the multiplier 35 is passed through the low pass filter 45, to attenuate a demodulated RDS signal. Only a demodulated ARI signal (DC control signal) is applied to the VCO 34', to stabilize the PLL.

On the other hand, if only the RDS signal is applied to an input terminal 31, the multiplier 35 performs quadrature detection on the modulated RDS signal. As a result, a carrier of the modulated RDS signal and the DC control signal are generated from the low pass filter 36. On this occasion, when the VCO 34' locks to a side-band wave of the modulated RDS signal, a large error signal is generated in the output of the LPF 36. However, if the low pass filter 45 exists, the above described large error signal is removed, so that the locking not to the carrier but to the side-band wave is maintained, causing erroneous detection. Thus, in the structure shown in Fig. 6, the LPF 45 is controlled by the output of the ARI detector 41, to solve the above described problem.

An operation of the circuit shown in Fig. 6 is the same as that of the circuit shown in Fig. 5. According to this circuit, the modulated ARI signal and the modulated RDS signal are separated, so that the demodulated RDS signal can be surely obtained.

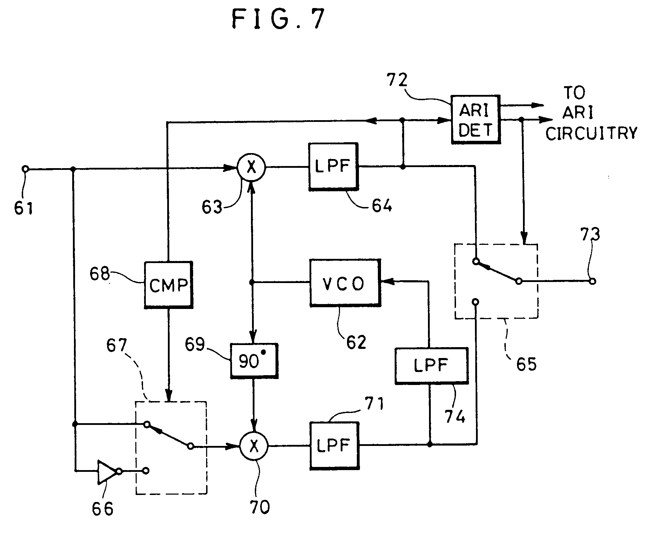

Fig. 7 is a diagram showing structure in which the present invention is applied to the reverse modulation circuit. Referring to Fig. 7, a DSB demodulator of a reverse modulation system comprises an IPS detection path, a PLL loop and a reverse modulation path.

The IPS detection path comprises a multiplier 63 for multiplying an input signal from an input terminal 61 by a signal from a VCO 62 to output a signal dependent on the phase difference therebetween, and a low pass filter 64 for passing a predetermined low frequency component of an output of the multiplier 63 to apply the same to one input terminal of a selector 65.

The reverse modulation path comprises a selector 67, responsive to a signal from a comparator 68 upon receipt of an input signal from the input terminal 61 and a signal through an inverter 66, for passing one of the received signals, thereby to output a signal obtained by reversely modulating the input signal. The comparator 68 receives an output of the low pass filter 64 and compares the same with a predetermined reference level, to generate a signal corresponding to the result of the comparison. In other words, the comparator 68 detects a zero cross point of an envelop of an input DSB modulated signal and generates a control signal at every zero cross point, to switch input terminals of the selector 67. Thus, even if the phase of an input carrier is inverted, an input carrier whose phase is continuous is obtained from the selector 67.

The PLL loop comprises a phase shifter 69 for shifting the output of the VCO 62 by 90° in the phase, a multiplier 70 for multiplying an output of the phase shifter 69 by the output of the selector 67, low pass filters 71 and 74 for passing a predetermined low pass frequency component of an output of the multiplier 70, and a VCO 62 for generating signals having a frequency corresponding to a signal voltage from the low pass filters 71 and 74.

The multiplier 70 outputs a signal corresponding to a phase difference between the output of the phase shifter 69 and the output of the selector 67. More specifically, the multiplier 70 compares the phases of the outputs of the phase shifter 69 and the selector 67, thereby to perform phase detection of the output of the selector 67. The output of the multiplier 70 is used as a frequency control voltage of the VCO 62 through the low pass filters 71 and 74.

In order to provide compatibility for an ARI signal and an RDS signal, there are provided an ARI detector 72 for determining whether or not the ARI signal is included in the output of the low pass filter 64, i.e., a demodulated signal, and a selector 65 responsive to an output of the ARI detector 72 for selecting one of the outputs of the low pass filters 64 and 71 to apply the same to an output terminal 73. The ARI detector 72 has substantially the same structure as those shown in Figs. 4 to 6, which comprises a low pass filter having a large time constant and a level detector for detecting an output level of the low pass filter.

In the above described structure, a regenerated carrier synchronized in phase with a carrier of a modulated ARI signal is developed from the VCO 62, a demodulated ARI signal is produced from the low pass filter 64 and a demodulated RDS signal is from the low pass filter 71. Thus, when the ARI signal and the RDS signal are simultaneously applied, if the selector 65 selects the output of the low pass filter 71 under control of the ARI detector 72, then the demodulated RDS signal is obtained at the output terminal 73. If the output of the low pass filter 64 reaches the zero cross point so that the phase of the input carrier is inverted, an input signal inverted in the phase is applied to the multiplier 70 by the comparator 68 and the selector 67. Thus, the same regenerated carrier is outputted from the VCO 62, of which phase is continuous with the phase of a regenerated carrier which has been being generated. Consequently, a signal obtained by inverting the polarity of a previously received signal (a signal being received before reaching the zero cross point) is outputted from the low pass filter 64, so that a DSB demodulated signal is surely obtained. Since the selector 67 modulates the input signal in response to the polarity of the demodulated RDS signal, the selector 67 has a function of reversely modulating the input signal.

According to the reverse modulation circuit, compatibility for the RDS signal and the ARI signal is provided, and the RDS signal can be surely demodulated.

In the above described embodiments, description was not made on the case in which only the ARI signal is applied. In this case, the output of the low pass filter included in the ARI detector becomes a demodulated ARI signal. Thus, if the demodulated signal is applied to ARI signal processing circuitry, the DK signal and the BK signal can be detected therein. The SK signal can be detected by the output of the ARI detector.

As described in the foregoing, according to the present invention, in the DSB demodulator having the first and second synchronous detection paths each for performing synchronous detection which are in a quadrature phase relation, there is provided structure in which one of the signals from the first and second synchronous detection paths is selectively passed, depending on the output signal level of the first synchronous detection path. Thus, there is provided a DSB demodulator which can surely output a signal obtained by demodulation of one of two modulated signals orthogonal to each other in the phase even if the modulated signals are simultaneously applied.

In addition, according to the present invention, in the DSB demodulator having the IPS detection path and the QS detection path, there is provided structure in which one of the IPS detected output and the QS detected output is selected in response to the output signal level of the IPS detection path, to be outputted. Thus, even if input modulated signals comprising quadrature modulated components such as the RDS signal and the ARI signal are applied, a signal obtained by demodulating one of the modulated signals can be always surely obtained.

Furthermore, according to the present invention, in the DSB demodulator having the IPS detection path and the QS detection path, there is provided structure in which an QS detected output is selected when the level of an IPS detected output is a predetermined value or more, and the IPS detected output is otherwise selected. Thus, even if a carrier suppressed AM signal and a carrier non-suppressed AM signal orthogonal to each other are simultaneously applied, a signal obtained by demodulating the carrier suppressed AM signal is always obtained.

Additionally, according to the present invention, in the DSB demodulator for demodulating the RDS signal and the ARI signal, the presence or absence of the ARI signal is detected in response to the level of the IPS detected output. The DSB demodulator selects the QS detected output when the ARI signal exists while otherwise selecting the IPS detected output. Thus, there is provided a demodulator which can always output the demodulated RDS signal.

Additionally, since the output of the ARI detector is applied to the ARI signal processing portion, a DSB demodulator which is compatible for the ARI signal and the RDS signal can be achieved.

## Claims

1. A device for demodulating a double side band signal externally applied having first synchronous detection means (2, 4, 5) for synchronously detecting an input modulated signal in a first phase relation and second synchronous detection means (3, 4, 8, 10) for synchronously detecting the input modulated signal in a quadrature phase relation to said first phase relation;
**characterized by:**
means (11, 41, 72) for determining whether or not a predetermined first signals is included in an output signal from said first synchronous detection means, and
means (12, 42, 65) responsive to a signal indicating the result of the determination from said determining means for selectively passing one of outputs of said first and second synchronous detection means.

2. The demodulator according to claim 1, wherein
said first detection means provides in-phase synchronous detection of the input modulated signal, and
said second detection means provides quadrature synchronous detection of the input modulated signal.

3. The demodulator according to any of claims 1 and 2, wherein
said double side band modulated signal comprises a first modulated signal obtained by amplitude modulation of said first signal and a second modulated signal obtained by amplitude modulation of a second signal which is different from said first signal such that the phase thereof is in a quadrature relation to the phase of said first modulated signal, and
said selecting means is controlled such that said second signal is always outputted.

4. The demodulator according to claim 3, wherein
said first modulated signal is an amplitude-modulated signal having a carrier and said second modulated signal is a carrier suppressed amplitude-modulated signal, and
said selecting means selects the output of said second synchronous detection means when said determining means determines the presence of said first signal while selecting the output of said first synchronous detection means when said determining means determines the absence of said first signal.

5. The demodulator according to any of claims 1 to 4, wherein
said determining means comprises means for detecting the output level of said first synchronous detection means to compare the same with a predetermined reference level.

6. The demodulator according to any of claims 1 to 5, wherein
said first signal comprises an ARI signal and said second signal comprises an RDS signal.

7. The demodulator according to any of claims 1 to 6, wherein
said demodulator comprises a Costas loop circuit.

8. The demodulator according to any of claims 1 to 6, wherein
said demodulator comprises a remodulation compare circuit.

9. The demodulator according to claim 8, wherein said remodulation compare circuit comprises
a voltage controlled oscillator (34') for deriving a signal locked to a signal having a predetermined frequency included in an input signal, and
a multiplier (35) and first and second low pass filters (36, 45) for generating a signal voltage for controlling the frequency of an output signal of said voltage controlled oscillator,
said second low pass filter (45) being responsive to an output of said determining means for being controlled in the filtering characteristics.

10. The demodulator according to claim 8, wherein
said second low pass filter is controlled such that the time constant provided when the input signal includes only the RDS signal is smaller than the time constant provided when the input signal includes the RDS signal and the ARI signal.

11. The demodulator according to any of claims 1 to 6, wherein
said demodulator comprises a reverse modulation circuit.

12. A method for demodulating double side band modulated signal, comprising the steps of:
performing in-phase synchronous detection of an input modulated signal,
performing quadrature synchronous detection of the input modulated signal, **characterized by:**
determining whether or not a predetermined signal is included in an in-phase synchronous detected output, and
selecting one of the in-phase synchronous detected output and a quadrature synchronous detected output in response to the result of the determination in said determining step.

13. The method according to claim 12, wherein
said double side band modulated signal comprises a carrier non-suppressed amplitude-modulated signal and a carrier suppressed amplitude-modulated signal, said two modulated signals being quadrature-modulated.
said determining step comprises the step of detecting a signal obtained by demodulating said carrier non-suppressed amplitude-modulated signal, and
said selecting step comprises the step of selectively passing said quadrature synchronous detected output to apply the same to an output terminal in response to the detection of the signal obtained by demodulating said carrier non-suppressed amplitude-modulated signal in said determining step.

14. The method according to claim 12 or 13, wherein said quadrature synchronous detection step comprises the steps of:
generating a signal locked to a carrier included in the input modulated signal,
determining whether or not an in-phase synchronous detection output signal crosses a predetermined reference level, and
inverting the phase of said locked signal in response to the cross determination in the determining step.

15. The method according to any of claims 12 and 13, wherein said quadrature synchronous detection step comprising the steps of:
generating a signal locked to a carrier included in an input modulated signal wave,
determining whether or nor said in-phase synchronous detected output crosses a predetermined reference level, and
inverting the phase of the signal of said input modulated signal wave in response to the cross determination in the determining step.

16. The method according to any of claims 12 and 13, which further comprises the steps of:
multiplying said in-phase synchronous detected output by said quadrature synchronous detected output, and
generating a signal locked to the carrier included in said input modulated signal under control of the result of said multiplication.

17. The method according to claim 13, wherein
said carrier suppressed amplitude-modulated signal comprises an RDS signal and said carrier non-suppressed amplitude-modulated signal comprises an ARI signal.

## Patentansprüche

1. Vorrichtung zum Demodulieren eines extern angelegten Zweiseitenband-Signals mit einer ersten Synchron-Detektoreinrichtung (2, 4, 5) zum synchronen Detektieren eines modulierten Eingangssignals in einer ersten Phasenbeziehung und einer zweiten Synchron-Detektoreinrichtung (3, 4, 8, 10) zum synchronen Detektieren des modulierten Eingangssignals in einer Quadratur-Phasenbeziehung zur ersten Phasenbeziehung,
**gekennzeichnet** durch:
eine Einrichtung (11, 41, 72) zum Bestimmen, ob in einem Ausgangssignal der ersten Synchrondetektoreinrichtung ein vorbestimmtes erstes Signal enthalten ist,
und
eine Einrichtung (12, 42, 65), die auf ein Signal anspricht, welches das Ergebnis der Bestimmung von der Bestimmungseinrichtung ist, um selektiv einen der Ausgänge der ersten und zweiten Synchron-Detektoreinrichtungen passieren zu lassen.

2. Demodulator nach Anspruch 1,
dadurch **gekennzeichnet,** daß die erste Detektoreinrichtung eine gleichphasige, synchrone Detektion des modulierten Eingangssignals durchführt und daß
die zweite Detektoreinrichtung eine synchrone Quadratur-Detektion des modulierten Eingangssignals durchführt.

3. Demodulator nach einem der Ansprüche 1 und 2,
dadurch **gekennzeichnet,** daß das Zweiseitenband-Signal aufweist ein erstes moduliertes Signal, das durch eine Amplitudenmodulation des ersten Signals erhalten wird, und ein zweites moduliertes Signal, das durch eine Amplitudenmodulation eines zweiten Signals, welches sich vom ersten Signal dadurch unterscheidet, daß seine Phase gegenüber der Phase des ersten modulierten Signals um 90° verschoben ist, erhalten wird, und
daß die Wähleinrichtung so gesteuert ist, daß das zweite Signal immer ausgegeben wird.

4. Demodulator nach Anspruch 3,
dadurch **gekennzeichnet,** daß das erste modulierte Signal ein amplitudenmoduliertes Signal mit einer Trägerwelle und das zweite modulierte Signal ein amplitudenmoduliertes Signal mit unterdrücktem Träger ist und
daß die Wähleinrichtung den Ausgang der zweiten SynchronDetektoreinrichtung wählt, wenn die Bestimmungseinrichtung die Anwesenheit des ersten Signals feststellt, während sie den Ausgang der ersten Synchron-Detektoreinrichtung wählt, wenn die Bestimmungseinrichtung die Abwesenheit des ersten Signals feststellt.

5. Demodulator nach einem der Ansprüche 1 bis 4,
dadurch **gekennzeichnet,** daß die Bestimmungseinrichtung Mittel zum Detektieren des Ausgangspegels der ersten Synchron-Detektoreinrichtung hat, um diesen mit einem vorbestimmten Bezugspegel zu vergleichen.

6. Demodulator nach einem der Ansprüche 1 bis 5,
dadurch **gekennzeichnet,** daß das erste Signal ein ARI-Signal und das zweite Signal ein RDS-Signal aufweist.

7. Demodulator nach einem der Ansprüche 1 bis 6,
dadurch **gekennzeichnet,** daß der Demodulator eine Costas-Schleifenschaltung aufweist.

8. Demodulator nach einem der Ansprüche 1 bis 6,
dadurch **gekennzeichnet,** daß der Demodulator eine Modulationsübertragungs-Vergleicherschaltung hat.

9. Demodulator nach Anspruch 8,
dadurch **gekennzeichnet**, daß die Modulationsübertragungs-Vergleicherschaltung aufweist:
einen spannungsgesteuerten Oszillator (34') zum Ableiten eines Signals, synchronisiert mit einem Signal, mit einer vorbestimmten Frequenz, das in einem Eingangssignal enthalten ist, und
einen Vervielfacher (35) und einen ersten und einen zweiten Niederpaßfilter (36, 45) zum Erzeugen einer Signalspannung zum Steuern der Frequenz eines Ausgangssignals des spannungsgesteuerten Oszillators,
wobei das zweite Niederpaßfilter (45) auf einen Ausgang der Bestimmungseinrichtung anspricht zur Steuerung seiner Filtercharakteristika.

10. Demodulator nach Anspruch 8,
dadurch **gekennzeichnet**, daß das zweite Niederpaßfilter so gesteuert ist, daß die Zeitkonstante, die verwendet wird, wenn das Eingangssignal nur das RDS-Signal enthält, kleiner ist als die Zeitkonstante, die verwendet wird, wenn das Eingangssignal das RDS-Signal und das ARI-Signal enthält.

11. Demodulator nach einem der Ansprüche 1 bis 6,
dadurch **gekennzeichnet**, daß der Demodulator eine Umkehrmodulations-Schaltung aufweist.

12. Verfahren zum Demodulieren eines modulierten Zweiseitenband-Signals mit den Schritten:
Durchführen der phasengleichen, synchronen Detektion eines modulierten Eingangssignals,
Durchführen einer quadraturmodulierten Synchron-Detektion des Eingangssignals,
**gekennzeichnet** durch die Schritte:
Bestimmen, ob ein vorbestimmtes Signal in einen phasengleichen, synchron-detektierten Ausgangssignal enthalten ist oder nicht, und
Wählen eines der Ausgangssignale von den phasengleichen, synchron detektierten Ausgang und einen quadraturmodulierten synchron-detektierten Ausgang, in Abhängigkeit von dem Ergebnis der Bestimmung in dem Bestimmungsschritt.

13. Verfahren nach Anspruch 12,
dadurch **gekennzeichnet**, daß das modulierte Zweiseitenband-Signal ein amplitudenmoduliertes Signal mit nicht unterdrücktem Träger und ein amplitudenmoduliertes Signal mit unterdrücktem Träger aufweist, wobei die zwei modulierten Signale quadratur-moduliert sind,
daß der Bestimmungsschritt den Schritt Detektieren eines Signals, welches durch Demodulieren des amplitudenmodulierten Signals mit nicht unterdrücktem Träger erhalten wird, aufweist, und
daß der Wählschritt den Schritt selektives Durchlassen des quadraturmodulierten synchron-detektierten Ausgangs aufweist, um diesen in Abhängigkeit von der Detektion des Signals, welches durch Demodulieren des amplitudenmodulierten Signals mit nicht unterdrücktem Träger im Bestimmungsschritt erhalten worden ist, an eine Ausgangsklemme anzulegen.

14. Verfahren nach Anspruch 12 oder 13,
dadurch **gekennzeichnet**, daß der synchrone Quadratur-Detektionsschritt die Schritte aufweist:
Erzeugen eines Signals, synchronisiert mit einem Träger, der im modulierten Eingangssignal enthalten ist;
Bestimmen ob ein phasengleiches, synchrones Detektions-Ausgangssignal einen vorbestimmten Bezugspegel kreuzt oder nicht; und
Umkehren der Phase des synchronisierten Signals in Abhängigkeit davon, ob in der Bestimmungsstufe ein Kreuzen ermittelt worden ist.

15. Verfahren nach einem der Ansprüche 12 und 13,
dadurch **gekennzeichnet,** daß der synchrone Quadratur-Detektionsschritt die Schritte aufweist:
Erzeugen eines Signals, synchronisiert mit einem Träger, der in der modulierten Eingangssignalwelle enthalten ist; Bestimmen, ob der phasengleiche, synchrone Detektionsausgang einen vorbestimmten Bezugspegel kreuzt oder nicht, und Umkehren der Phase des Signals der modulierten Eingangssignalwelle in Abhängigkeit davon, ob in der Bestimmungsstufe ein Kreuzen ermittelt worden ist.

16. Verfahren nach einem der Ansprüche 12 und 13,
**gekennzeichnet** durch die weiteren Schritte:
Multiplizieren des phasengleichen, synchron detektierten Ausgangs mit dem quadraturmodulierten, synchron-detektierten Ausgang und
Erzeugen eines Signals synchronisiert zum Träger, der in dem modulierten Eingangssignal enthalten ist, gesteuert durch das Ergebnis der Multiplikation.

17. Verfahren nach Anspruch 13, dadurch **gekennzeichnet**, daß das amplitudenmodulierte Signal mit unterdrücktem Träger ein RDS-Signal enthält und daß das amplitudenmodulierte Signal mit nicht unterdrücktem Träger ein ARI-Signal enthält.

## Revendications

1. Dispositif pour démoduler un signal à bande latérale double appliqué de manière externe comprenant des premiers moyens de détection synchrone (2, 4, 5) pour détecter de manière synchrone un signal d'entrée modulé en une première relation de phase et des seconds moyens de détection synchrone (3, 4, 8, 10) pour détecter de manière synchrone le signal d'entrée modulé en relation de quadrature de phase avec ladite première relation de phase, caractérisé en ce que :
des moyens (11, 41, 72) servant à déterminer si un premier signal prédéterminé est ou non inclus dans un signal de sortie provenant du premier moyen de détection synchrone, et
des moyens (12, 42, 65) sensibles à un signal indiquant le résultat de la détermination à partir du premier moyen de détermination pour envoyer sélectivement l'une des sorties des premier et second moyens de détection synchrone.

2. Démodulateur selon la revendication 1, dans lequel
le premier moyen de détection assure une détection en phase synchrone du signal d'entrée modulé, et
dans lequel le second moyen de détection assure une détection de quadrature synchrone du signal d'entrée modulé.

3. Démodulateur selon l'une quelconque des revendications 1 et 2, dans lequel
le signal modulé à bande latérale double comprend un premier signal modulé obtenu par modulation d'amplitude du premier signal et un second signal modulé obtenu par modulation d'amplitude d'un second signal qui est différent du premier signal de façon telle que la phase de celui-ci est en relation de quadrature avec la phase du premier signal modulé, et
le moyen de sélection est commandé de manière telle que le second signal est toujours délivré.

4. Démodulateur selon la revendication 3, dans lequel
le premier signal modulé est un signal à amplitude modulé comportant une porteuse et dans lequel le second signal modulé est un signal à amplitude modulé à porteuse supprimée, et
dans lequel le moyen de sélection sélectionne la sortie du second moyen de détection synchrone lorsque le moyen de détermination détermine la présence du premier signal tout en sélectionnant la sortie du premier moyen de détection synchrone lorsque le moyen de détermination détermine l'absence du premier signal.

5. Démodulateur selon l'une quelconque des revendications 1 à 4, dans lequel
le moyen de détermination comprend un moyen pour détecter le niveau de sortie du premier moyen de détection synchrone pour comparer celui-ci à un niveau de référence prédéterminé.

6. Démodulateur selon l'une quelconque des revendications 1 à 5, dans lequel
le premier signal comprend un signal ARI et dans lequel le second signal comprend un signal RDS.

7. Démodulateur selon l'une quelconque des revendications 1 à 6, dans lequel
le démodulateur comprend un circuit à boucle Costas.

8. Démodulateur selon l'une quelconque des revendications 1 à 6, dans lequel
le démodulateur comprend un circuit de comparaison de remodulation.

9. Démodulateur selon la revendication 8, dans lequel le circuit de comparaison de remodulation comprend
un oscillateur à tension commandée (34') pour déduire un signal verrouillé sur un signal comportant une fréquence prédéterminée incluse dans un signal d'entrée, et
un multiplicateur (35) et des premier et second filtres passe-bas (36, 45) pour produire une tension de signal servant à commander la fréquence d'un signal de sortie de l'oscillateur à tension commandée,
le second filtre passe-bas (45) étant sensible à une sortie du moyen de détermination pour être commandé dans les caractéristiques de filtrage.

10. Démodulateur selon la revendication 8, dans lequel le second filtre passe-bas est commandé de manière telle que la constante de temps prévue lorsque le signal d'entrée comprend seulement le signal RDS est plus petite que la constante de temps prévue lorsque le signal d'entrée comporte le signal RDS et le signal ARI.

11. Démodulateur selon l'une quelconque des revendications 1 à 6, dans lequel
le démodulateur comprend un circuit de modulation inverse.

12. Procédé pour la démodulation d'un signal modulé à bande latérale double, comprenant les étapes consistant à :
effectuer une détection en phase synchrone d'un signal d'entrée modulé,
effectuer une détection de quadrature synchrone du signal d'entrée modulé, caractérisé en ce que :
déterminer si un signal prédéterminé est ou non inclus dans une sortie en phase synchrone détectée, et
sélectionner l'une des sorties en phase synchrone détectées et une sortie à quadrature synchrone détectée en réponse au résultat de la détermination au cours de l'étape de détermination.

13. Procédé selon la revendication 12, dans lequel
le signal modulé à bande latérale double comprend un signal à amplitude modulé à porteuse non supprimée et un signal à amplitude modulé à porteuse supprimée, les deux signaux modulés étant à quadrature modulée,
l'étape de détermination comprend l'étape de détection d'un signal obtenu par démodulation du signal à amplitude modulée à porteuse non supprimée, et
l'étape de sélection comprend l'étape consistant à envoyer sélectivement la sortie à quadrature synchrone détectée pour appliquer celle-ci à une borne de sortie en réponse à la détection du signal obtenu par démodulation du signal à amplitude modulé à porteuse non supprimée au cours de l'étape de détermination.

14. Procédé selon la revendication 12 ou 13, dans lequel l'étape de détection de quadrature synchrone comprend les étapes consistant à :
produire un signal verrouillé sur une porteuse comprise dans le signal d'entrée modulé,
déterminer si un signal de sortie de détection en phase synchrone croise ou non un niveau de référence prédéterminé, et
inverser la phase du signal verrouillé en réponse à la détermination de croisement au cours de l'étape de détermination.

15. Procédé selon l'une quelconque des revendications 12 et 13, dans lequel l'étape de détection de quadrature synchrone comprenant les étapes consistant à :
produire un signal verrouillé sur une porteuse comprise dans une onde de signal d'entrée modulé,
déterminer si la sortie en phase synchrone détectée croise ou non un niveau de référence prédéterminé, et
inverser la phase du signal de l'onde de signal d'entrée modulé en réponse à la détermination de croisement au cours d'une étape de détermination.

16. Procédé selon l'une quelconque des revendications 12 et 13, qui comporte en outre les étapes consistant à :
multiplier la sortie en phase synchrone détectée par la sortie à quadrature synchrone détectée, et
produire un signal verrouillé sur la porteuse comprise dans le signal d'entrée modulé sous le contrôle du résultat de la multiplication.

17. Procédé selon la revendication 13, dans lequel
le signal à amplitude modulé à porteuse supprimée comporte un signal RDS et dans lequel le signal à amplitude modulé à porteuse non supprimée comporte un signal ARI.
